# EUROPEAN PATENT SPECIFICATION

(11) **EP 0 557 079 B1**
(45) Date of publication and mention of the grant of the patent: **23.12.1998**
(21) Application number: 93301161.1
(22) Date of filing: 17.02.1993
(51) Int. Cl.: G06F 11/20, H01L 23/525, H01L 21/66

(54) **Discretionary lithography for integrated circuits**
Lithographie nach Bedarf für integrierte Schaltungen
Lithographie discrétionnaire pour circuits intégrés

(30) Priority: 18.02.1992 US 838157
(43) Date of publication of application: 25.08.1993
(73) Proprietor: Elm Technology Corporation, Montecito, CA 93108 (US)
(72) Inventor: Leedy, Glenn J., Santa Barbara, California 93108 (US)
(74) Representative: Jones, Ian

(56) References cited:
- US-A- 3 618 201
- US-A- 3 702 025
- US-A- 4 924 589

## Description

The invention relates to a method of fabricating integrated circuits, using one or more fixed masks.

Integrated circuits (ICs) include active and passive elements such as transistors, diodes, resistors, and capacitors, that are interconnected in a predetermined pattern to perform desired functions. The interconnections are effectuated by means of metallization layers and vias. A "via" is a hole through an insulation layer in which conductor material is located to electrically interconnect one conductive layer to another or to an active or passive region in the underlying semiconductor substrate. Present day technology generally employs two metallization layers that are superimposed over the semiconductor wafer structure. Integrated circuits and assemblies have become more complex with time and in a logic circuit, the number of integrated circuit logic units (ICLUs) and interconnects on a given size die have been substantially increased reflecting improved semiconductor processing technology. An ICLU is an IC element and can be a device (such as a transistor), a gate (several transistors) or as many as 25 or more transistors and other devices. As is well known in the art, each ICLU is connected to other ICLUs by conductive contact points which have a typical center-to-center spacing of about 6 to 15 microns (µm).

Standard processing to make logic structures (e.g., gate arrays) includes first fabricating as many as half a million transistors comprising a quarter of a million gates per die. Each semiconductor wafer (typically silicon but sometimes of other material such as gallium arsenide) includes many die, for example, several hundred. In one type of gate array, for example, the transistors are arrayed in rows and columns on each die, and each transistor is provided with conductive contact points (typically metal but sometimes formed of other conductive material such as doped polycrystalline silicon), also arrayed in rows and columns.

In the prior art, the next step is to use fixed masks to fabricate the conductive layers (sometimes called "metallization layers"), to connect together the individual gate-array devices. Typically two or sometimes three metallization layers are used.

After this, the completed die is tested. If any of the devices on the die are defective, that die will fail an exhaustive test and be scrapped. Therefore, the more transistors per die the lower the manufacturing yield. In some cases redundant sections of a circuit are provided that can be substituted for defective sections of a circuit by fuses after metallization. Typically such redundant sections can be 5% to 10% of the total circuit.

As stated above, the prior art fabricates a plurality of transistors on a die, interconnects the transistor to form desired logic, tests the entire die, and scraps the die if the logic doesn't work.

Contrasting methods are disclosed in related U.S. Patents 4 924 589 & 5 103 557. As will appear from these related U.S. Patents, after fabricating the transistors exactly as before, the transistors or ICLUs are tested individually. Then the interconnect scheme is modified, if necessary, by CAD means (of well known design) to bypass defective transistors or ICLUs and substitute, logically speaking, replacement (redundant) ICLUs. Then the metallization layers are deposited and patterned in accordance with the modified interconnect scheme, in one embodiment by E-beam (Electron-beam) lithography, instead of the masking process of the usual conventional technology. Thus each die has its own unique interconnect scheme, even though each die is to carry out the same function as the other die.

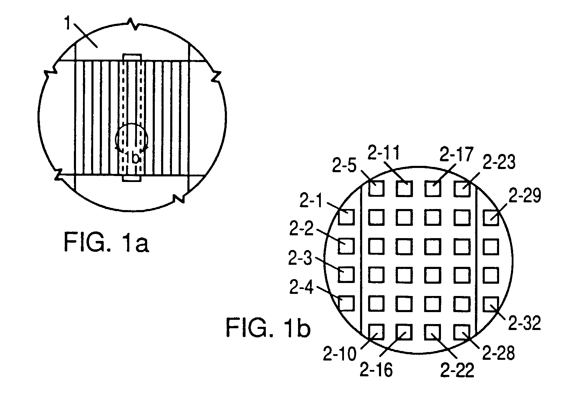

One begins with a gate array IC conventionally fabricated on a silicon or GaAs wafer although standard cell or full custom IC designs can just as easily be used. Reference is now made to Figures 1a & 1b of the accompanying drawings, which show a section of a gate array wafer. Figure 1b is an enlarged view of the portion of Figure 1a shown in the circle marked "1b". The gate array transistors are arrayed in columns and rows on the wafer surface 1, and the active regions of each transistor are provided with contact points such as 2-1 to 2-32 which are in columns and rows as shown in Figure 1b (not all contact points are numbered). Redundant (or extra) devices are designed into each column, with a redundancy factor dependent on the expected yield of the individual transistors or ICLUs being tested.

The surface of the wafer 1 is optionally planarized with a cured layer of polyimide 0.8 to 1.5 micron thick if the step heights between contact points are greater than 0.5 microns. (The contact points 2-1 to 2-32 are masked from the polyimide layer, to create a via over each contact point free of polyimide, and metal is deposited to fill the via.)

The fabricated (but not metallized) wafer 1 is now ready for testing. Sometimes only one column of transistors on each die is tested at a time; testing more than one column, the whole die or several die per step is also possible. For a die of typical complexity this requires making contact with all of the perhaps 10,000 or so contact points such as 2-1 to 2-4 in one column simultaneously, and then stepping across all 100 or 200 or more columns in each die, to exhaustively test each die in step-and-repeat fashion. Each contact point such as 2-1 is small such as usually 4 X 4 microns in area. Each wafer contains a plurality of die, the exact number depending on the size of the wafer but typically being in the hundreds.

The data resulting from the testing is a list of the location of each of the defective transistors or ICLUs. This list is automatically communicated to a conventional CAD system from a tester signal processor. The CAD system then, by special software algorithms, works out interconnect changes for each die. Each interconnect change required due to a defective ICLU typically affects ICLU interconnects over an area of no greater than 100 µm in diameter. Therefore, the master placement scheme of the net list is modified in terms of the placement of the defective ICLUs so as to bypass the defective ICLUs and interconnect defect-free ICLUs from the stock of redundant ICLUs.

The above-mentioned related patents (as described in detail therein) use two alternative software algorithms for interconnects: recomputation of metallization trace routing or a CAD rip-up router.

A modified routing database as provided by either of these methods is next used to produce the database for the desired interconnect patterns on the wafer using in one embodiment E-beam equipment. The metallization process is in one embodiment a two layer metallization, although a single layer of metallization or three or more layers of metallization can also be used. The metallization process involves depositing a layer of insulation, such as silicon dioxide, typically of about one micron thickness over the wafer surface, and cutting vias by means of a mask to the contact points on the wafer surface through the silicon dioxide layer. Then a layer of metal, typically aluminum, is deposited over the silicon dioxide. Then a layer of photoresist is deposited and patterned, for example, using E-beam (maskless) lithography. The E-beam is controlled by the CAD database means and its modified net list to make the desired interconnect pattern corrected in accordance with the test results. The photoresist is then developed and removed where exposed to the E-beam (if positive resist), allowing the patterning of the interconnects as desired.

The metallization (i.e., interconnect) process is then repeated for the second metallization layer and any subsequent metallization layers. The metallization process is generally well known technology.

At this point the wafer is complete, ready for scribing, packaging and final test as usual.

The invention provide a method of fabricating integrated circuits as defined in the appended claims.

In one embodiment of the invention, a stepper-scanner apparatus is used modified to expose most of a resist layer defining the interconnect circuitry, but the exposure is interrupted or shuttered-off at the locations of the discretionary interconnect changes. In a later step the discretionary interconnect changes are exposed by a conventional direct write-on-wafer pattern generation apparatus.

Also, in accordance with the invention, the interconnect patterning is accomplished in two main steps. First one or more fixed masks (typically two, one metal and one via mask) for the mask layers requiring modification is fabricated for defining the interconnect layer for a particular lot (such as 100) of wafers. The fixed masks are fabricated after each wafer has been exhaustively tested, and the fixed masks incorporate all the discretionary changes required to avoid interconnection to each defective circuit element in all of the 100 wafers. The fixed custom masks are then used to expose the resist layer defining the interconnect circuitry for all of the 100 wafers.

The present invention improved on the above-described art by making fabrication of the metallization (interconnect) faster and hence less expensive than by patterning the entire interconnect by E-beam. Prior methods require the separate application and processing of more than one resist layer, and/or two separate etch processing steps of the same metal layer or via layer. The present methods cost (depending on lot size) less than 1/4 as much as the non-E-beam methods and less than 1/20 of an all E-Beam pattern generation (direct write) method.

The invention thus permits the fabrication of very large integrated circuits, in terms of the number of ICLUs or devices per circuit, by discretionary fine-grain resist layer patterning in situ to a fixed mask pattern exposure or by fabrication of a custom mask to pattern on each wafer a discretionary layer incorporating all discretionary changes for a specific lot of wafers.

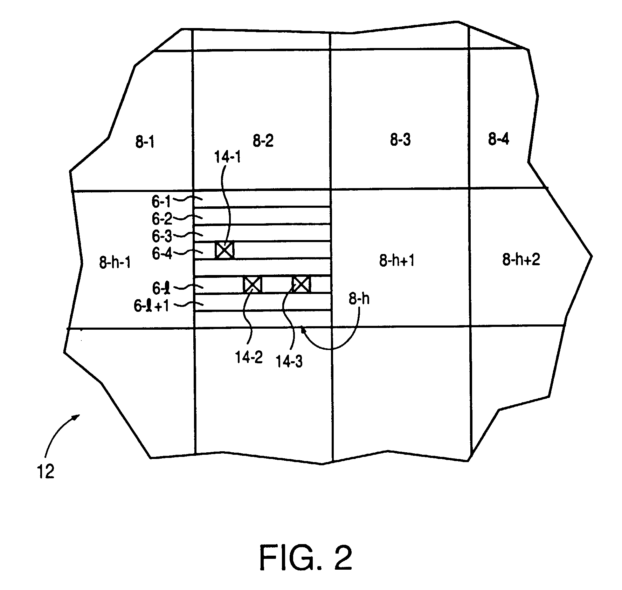

The invention is further described below, by way of example, with reference to Figure 2 of the accompanying drawings which shows stepper scanner discretionary lithography.

In accordance with the present invention, instead of using the results of the recomputation of metallization trace routing or a CAD rip-up router as described above to pattern the interconnect using E-beam maskless lithography as in one embodiment, the interconnect is fabricated by one of the two following methods both of which involve the use of fixed mask(s).

This first method uses the fine-grain IC CAD and ICLU defect test databases generated as described above and in the related patents to prevent the exposure of a fixed mask pattern over the defective ICLU sites during the exposure of a fixed mask. The IC CAD and ICLU defect databases are used to compute the definition (dimension) and location of discretionary areas of the fixed mask image that are not to be exposed or imaged during the primary exposure of the fixed mask onto the resist of the substrate.

The ICLU defect database identifies by locator index (e.g. row m, column n) or identification index a defective ICLU of a specific die. This index is then used to look up the physical dimension of the ICLU in the IC CAD database. All layout specific information and even the identification and routing connections of the redundant ICLU to be used to replace the defective ICLU may be provided by the IC CAD database. The dimensions to be used for the defective replacement ICLU are typically directly read from the IC CAD database, or can be easily computed from the placement coordinates of adjacent ICLUs.

The discretionary areas of the resist layer that are not imaged during the primary exposure or imaging of the fixed mask are subsequently imaged by an optical pattern generating lithography tool or a non-optical patterning generating lithography tool such as E-beam or Ion-beam equipment. The control of the exposure of discretionary areas by these lithography tools with regard to fixed mask and pattern generation processing is derived from the IC CAD and ICLU defects databases. This is done in the same manner used conventionally for reducing a complete IC mask layer into pattern generation instructions for a mask making tool, the difference here only being that a very small subset of a mask layer is being processed.

This discretionary lithography method derives its advantage from the fine-grain nature of the tester ICLU defect database. The IC CAD and fine-grain ICLU defect databases provide the information to determine definition and placement of rectangular areas in the fixed mask pattern of a layer of an IC that requires discretionary imaging. The size of these areas is small, typically less than 100µm by 100µm and they are few in number, there being typically less than two per cm² or whatever the defect density of the semiconductor process that is being employed. The small area of each ICLU defect and the low ICLU defect density provide the basis for utilizing fixed mask lithography and not requiring the generation of a separate mask pattern. Due to the short length and local nature of each discretionary interconnect change, the electrical operational parameters of the IC are unaffected, or these circuit parameters remain within the band-width of the original circuit timing simulation. Discretionary changes in situ to the imaged pattern of the fixed mask are achieved in a common resist layer. This method requires no additional resist application or etch processing steps other than those already required by the IC fabrication process being employed.

This method of fine-grain discretionary lithography uses a commercially available lithography tool called a stepper scanner. This newly developed lithography tool operates in a manner identical to conventional stepper lithography tools except instead of imaging the complete IC layer during resist exposure with a fixed mask, it exposes the resist layer with the pattern of a fixed mask by making incremental exposure scans or strips across the mask image until the complete mask area has been imaged onto the resist. These exposure scans dimensionally are the length of the mask and of variable width from 1 to several mils. Stepper scanner tools as now commercially available do not operate so as to prevent the exposure of the discretionary areas. However, these tools can easily be modified to do so by methods well within the knowledge of one skilled in the art. Such equipment is presently offered for sale by Silicon Valley Group, (Santa Clara, CA) and Image Micro Systems, Inc. (Billerica, MA.); several other lithography equipment manufacturers are expected soon to offer such equipment.

The modification of these tools is as follows. The placement or position and length of an ICLU in an exposure scan or strip is provided as data to the stepper-scanner tool. The exposure of the scan is shuttered or blocked from the left edge of the ICLU of interest to the right end of the scan. This exposes the area of the scan to the left of the ICLU of interest. A second scan exposure is made, and the area from the left end of the scan to the right edge of the ICLU of interest is shuttered or blocked. This exposes the area to the right of the ICLU. This is only one of several methods possible. All that is required to implement this method is a left and right shutter vane under the same computer control as the scanning stepper, and reading the discretionary ICLU exposure data. In some cases it will be necessary to change the height of the scan. This is accomplished under the same computer control and using the ICLU data. Shutter vanes capable of high precision vertical motion are used to adjust the height of the scan exposure.

Figure 2 shows scan exposures 6-1, 6-2, ..., 6-l, 6-l+1, ... of an individual IC 8-k on a substrate 12 containing multiple ICs 8-1, 8-2, ..., 8-k-1, 8-k, 8-k+1, ... during fabrication. The marked areas 14-1, 14-2, 14-3 indicate discretionary areas (not to scale) that were not exposed during the scanning of the IC 8-k with a fixed mask. Each IC 8-k would be expected to have a slightly different placement of discretionary areas consistent with the occurrences of defects within an individual IC.

The application of this stepper scanner lithography tool to fine-grain discretionary resist patterning is accomplished as follows. The scanner stepper lithography tool is programmed with the width of the scan exposure 6-l based on each defective ICLU 14-2, 14-3 placement and dimensional data. The exposing scan is positioned to have coincident edges with the upper and lower rectangular edges of the boundaries of each fine-grain discretionary area 14-1, 14-2, 14-3 containing an ICLU defect and the redundant ICLU (not shown) to be used to repair or replace each defective ICLU 14-1, 14-2, 14-3. The exposure scan 6-1 is then interrupted or shuttered-off when the exposure scan of a fixed mask (not shown) is directly over a fine-grain discretionary or defect area 14-1, 14-2, 14-3. This leaves the resist over the area of the defective ICLU 14-1, 14-2, 14-3 and its redundant replacement unpatterned, but all of the remaining portions of the fixed mask are conventionally imaged onto the resist layer (not shown) of the IC substrate 12.

The unpatterned discretionary areas 14-1, 14-2, 14-3 of the resist layer are then patterned with a pattern generating tool. Direct write-on-wafer pattern generation tools that can be used to pattern the resist in a discretionary area are presently manufactured by such companies as Research Devices (Piscataway, NJ), Ateq (Beaverton, Oregon), Etec Systems (Hayward, CA), and Seiko Instruments (Japan). The image of the resist is then transferred into the substrate 12 using whatever manner of semiconductor process technology that has been chosen.

This alternative method takes advantage of the statistical phenomenon that the likelihood of an ICLU defect also occurring in the redundant or replacement ICLU at some location more than once for all die in some particular lot size of wafers (such as 10 to 1,000 wafers) of a specific IC is near zero. This statistical phenomenon depends on the defect density of the semiconductor process technology being used, but is attributable to the fine-grain resolution of the ICLU test database. This method achieves discretionary changes through lithography processing by creating one or more fixed masks that incorporate all discretionary changes required by each defective ICLU for some number of wafers of a specific IC design. In this manner the cost of creating custom masks to accommodate discretionary interconnect metallization changes is averaged over the number of ICs that yield from a specific wafer lot size.

In this method, after the ICLUs have all been fabricated on some fairly large number of wafers (such as 100 wafers), each ICLU of each wafer is tested for defects as described above. Then using the resulting ICLU defect data base, typically two custom fixed masks for providing the desired interconnects are conventionally fabricated, except that wherever any of the ICLUs on any of the 100 wafers has a defect, interconnects are provided on the fixed masks connecting instead to a redundant ICLU. The fixed masks are thus customized for this particular lot of wafers and all die of the wafer lot will have the same via and metallization pattern. Typically two fixed masks are used - one for metallization and one for vias for redundant ICLU interconnection. If the redundant ICLUs may be connected with only one mask, then only one fixed mask is needed.

The fixed masks are then used to expose a resist layer on each of the 100 wafers, leaving any surface area on any of the wafers that includes a defective ICLU excluded from the interconnect circuitry and substituting therefore one of the redundant ICLUs.

This description is illustrative and not limiting; further modifications will be apparent to one of ordinary skill in the art in the light of this disclosure and the appended claims.

## Claims

1. A method of fabricating integrated circuits comprising the steps of:
fabricating a plurality of integrated circuit logic elements on a substrate;
testing each logic element and determining the presence of defects in each logic element;
determining the location and dimensions of each defect;
using a fixed mask to pattern electrical interconnects between the logic elements on a surface of the substrate, and leaving unpatterned predetermined portions of the surface of the substrate, wherein the unpatterned predetermined portions are defined by the location and dimensions of each defect; and
patterning the predetermined portions thereby interconnecting the logic elements and excluding the defects from the interconnected logic elements.

2. A method as claimed in claim 1 wherein the step of using a fixed mask includes the steps of:
scanning the surface of the substrate in a plurality of scans of variable width; and
interrupting the scanning at the predetermined portions, thereby leaving those predetermined portions unpatterned.

3. A method as claimed in claim 2 wherein the steps of scanning and interrupting are performed by a stepper scanner modified to avoid exposing the predetermined portions corresponding to the defects as determined in the step of testing.

4. A method as claimed in claim 2 or 3 wherein the widths of the scans are about 0,0254 to 0,127 mm (1 to 5 mils).

5. A method as claimed in claim 1, 2, 3 or 4 wherein the step of patterning comprises using a direct write on wafer pattern generation tool to pattern the predetermined portions.

6. A method of fabricating integrated circuits comprising the steps of:
fabricating a plurality of integrated circuit logic elements on each of a plurality of substrates;
testing each logic element on each substrate to determine the presence of defects in each logic element and the location of each defect;
fabricating at least one fixed mask for patterning of interconnect circuitry on each of the plurality of substrates, the fixed mask defining circuitry to avoid interconnection with each defect on each substrate; and
patterning each substrate by use of the fixed mask, thereby interconnecting the logic elements and excluding all the defects from the interconnected logic elements.

7. A method as claimed in claim 6 wherein the step of fabricating the at least one fixed mask includes fabricating one fixed mask for defining metallization and a second fixed mask for defining vias, and wherein the step of patterning includes using both fixed masks.

## Patentansprüche

1. Verfahren zur Herstellung integrierter Schaltungen, umfassend die folgenden Schritte:
Herstellen einer Mehrzahl von Logikelementen für eine integrierte Schaltung auf einem Substrat;
Prüfen jedes Logikelementes und Ermitteln der Anwesenheit von Defekten in jedem Logikelement;
Ermitteln des Ortes und der Abmessungen jedes Defektes;
Verwenden einer festen Maske zum Strukturieren elektrischer Verbindungen zwischen den Logikelementen auf einer Oberfläche des Substrats und Unstrukturiertlassen vorbestimmter Abschnitte der Oberfläche des Substrats, wobei die unstrukturierten vorbestimmten Abschnitte durch den Ort und die Abmessungen jedes Defektes definiert werden; und
Strukturieren der vorbestimmten Abschnitte, um so die Logikelemente miteinander zu verbinden und die Defekte von den verbundenen Logikelementen auszuschließen.

2. Verfahren nach Anspruch 1, bei dem der Schritt des Verwendens einer festen Maske die folgenden Schritte beinhaltet:
Abtasten der Oberfläche des Substrats in einer Mehrzahl von Abtastungen variabler Breite; und
Unterbrechen des Abtastens an den vorbestimmten Abschnitten, um dadurch diese vorbestimmten Abschnitte unstrukturiert zu lassen.

3. Verfahren nach Anspruch 2, bei dem die Schritte des Abtastens und Unterbrechens mit einem Inkrementalscanner durchgeführt werden, der so modifiziert ist, daß die vorbestimmten Abschnitte, die den Defekten gemäß Ermittlung in den Prüfschritten entsprechen, nicht belichtet werden.

4. Verfahren nach Anspruch 2 oder 3, bei dem die Abtastungsbreiten etwa 0,0254 - 0,127 mm (1 - 5 mil) betragen.

5. Verfahren nach Anspruch 1, 2, 3 oder 4, bei dem der Strukturierungsschritt die Verwendung eines Direktschreib-Strukturgenerierungswerkzeuges umfaßt, um die vorbestimmten Abschnitte zu stukturieren.

6. Verfahren zur Herstellung integrierter Schaltungen, umfassend die folgenden Schritte:
Herstellen einer Mehrzahl von Logikelementen für eine integrierte Schaltung auf jedem aus einer Mehrzahl von Substraten;
Prüfen jedes Logikelementes auf jedem Substrat, um die Anwesenheit von Defekten in jedem Logikelement und den Ort jedes Defektes zu ermitteln;
Herstellen von wenigstens einer festen Maske zum Strukturieren einer Verbindungsschaltungsanordnung auf jedem aus der Mehrzahl von Substraten, wobei die feste Maske eine Schaltungsanordnung definiert, um eine Verbindung mit den einzelnen Defekten auf jedem Substrat zu vermeiden; und
Strukturieren jedes Substrats mit Hilfe der festen Maske, um so die Logikelemente miteinander zu verbinden und alle Defekte von den verbundenen Logikelementen auszuschließen.

7. Verfahren nach Anspruch 6, bei dem der Schritt des Herstellens der wenigstens einen festen Maske die Herstellung von einer festen Maske zum Definieren einer Metallisierung und von einer zweiten festen Maske zum Definieren von Verbindungskontakten beinhaltet, und wobei der Schritt des Strukturierens die Verwendung beider fester Masken beinhaltet.

## Revendications

1. Une méthode de fabrication de circuits intégrés qui comporte les étapes suivantes :
fabrication d'une pluralité d'éléments logiques à circuits intégrés sur un substrat;
essai de chaque élément logique et détermination de la présence de défauts dans chaque élément logique;
détermination de la position et des dimensions de chaque défaut;
utilisation d'un masque fixe pour graver des réseaux d'interconnexion électrique entre les éléments logiques sur une surface du substrat, en laissant sans réseaux des portions prédéterminées de la surface du substrat, les portions prédéterminées sans réseaux étant définies par la position et les dimensions de chaque défaut; et
gravure de motifs en réseau sur les portions prédéterminées de manière à interconnecter les éléments logiques et à exclure les défauts des éléments logiques interconnectés.

2. Une méthode selon la revendication 1, selon laquelle l'étape d'utilisation d'un masque fixe inclut les étapes suivantes :
scrutation de la surface du substrat en une pluralité de balayages de largeur variable; et
interruption du balayage aux positions prédéterminées, laissant ainsi sans motifs ces portions prédéterminées.

3. Une méthode selon la revendication 2, selon laquelle les étapes de balayage et d'interruption sont exécutées par un dispositif de balayage pas à pas modifié pour éviter d'exposer les portions prédéterminées correspondant aux défauts déterminés pendant l'étape d'essai.

4. Une méthode selon la revendication 2 ou 3, selon laquelle les largeurs des balayages sont d'environ 0,0245 à 0,127 mm (1 à 5 mils).

5. Une méthode selon les revendications 1, 2, 3 ou 4, selon laquelle l'étape de gravure de motifs comporte l'utilisation d'un outil de tracé de motifs par gravure directe pour former des motifs sur les portions prédéterminées.

6. Une méthode de fabrication de circuits intégrés comportant les étapes suivantes :
fabrication d'une pluralité d'éléments logiques à circuits intégrés sur chacun d'une pluralité de substrats;
essai de chaque élément logique sur chaque substrat pour déterminer le présence de défauts dans chaque élément logique et la position de chaque défaut;
fabrication d'au moins un masque fixe pour la gravure de motifs ou réseaux de circuits d'interconnexion sur chacun de la pluralité de substrats, le masque fixe définissant des circuits pour éviter l'interconnexion avec chaque défaut sur chaque substrat; et
gravure de motifs sur chaque substrat en utilisant le masque fixe, interconnectant ainsi les éléments logiques tout en excluant tous les défauts des éléments logiques interconnectés.

7. Une méthode selon la revendication 6, selon laquelle l'étape de fabrication dudit au moins un masque fixe inclut la fabrication d'un masque fixe pour définir la métallisation et d'un second masque fixe pour définir les traversées, et selon laquelle les étapes de gravure des motifs ou réseaux inclut l'utilisation des deux masques fixes.
